Europäisches Patentamt

European Patent Office

Office européen des brevets

(11) Veröffentlichungsnummer : **0 050 254 B1**

(19)

(12) **EUROPÄISCHE PATENTSCHRIFT**

(45) Veröffentlichungstag der Patentschrift :
30.01.85

(21) Anmeldenummer : 81107892.2

(22) Anmeldetag : 03.10.81

(51) Int. Cl.⁴ : **H 03 K 17/28**, H 03 K 17/30, G 06 F 1/00

(54) **Elektronisches Zeitglied.**

(30) Priorität : 18.10.80 DE 3039408

(43) Veröffentlichungstag der Anmeldung :
28.04.82 Patentblatt 82/17

(45) Bekanntmachung des Hinweises auf die Patenterteilung : 30.01.85 Patentblatt 85/05

(84) Benannte Vertragsstaaten :
AT CH FR GB LI SE

(56) Entgegenhaltungen :
DD-A-  142 933
DE-B- 1 762 794
US-A- 4 096 560
Patent Abstracts of Japan, Band 2, Nr. 56, 24. April
1978, Seite 1362E78
ELECTRONIC DESIGN, Nr. 7, 29. März 1978, D.R.
MORGAN "Get a controlled delay and ramp with a
single CMOS inverter package", Seite 86
ELEKTRONIK, Nr. 12, 1973, München, H. GAD "Erzeugung von Einschalt-Stellimpulsen", Seite 444
ELEKTRONIK, Band 16, Nr. 7, 1967, München, M.
HANEMANN "Elektronische Langzeitglieder", Seiten
207 bis 212

(73) Patentinhaber : Felten & Guilleaume Fernmeldeanlagen GmbH
Thurn-und-Taxis-Strasse 10 Postfach 4943
D-8500 Nürnberg 10 (DE)

(72) Erfinder : Fleischmann, Heinz
Pottensteiner Strasse 52
D-8500 Nürnberg (DE)
Erfinder : Steckmann, Helmut, Ing. Grad.
Karl-Plesch-Strasse 4
D-8501 Schwanstetten (DE)

(74) Vertreter : Peuckert, Hermann
Philips Patentverwaltung GmbH Billstrasse 80 Postfach 10 51 49
D-2000 Hamburg 28 (DE)

## Beschreibung

Die Erfindung betrifft ein elektronisches Zeitglied zur Erzeugung von Steuersignalen für ein elektrisches Gerät, gemäß dem Oberbegriff des Anspruchs 1.

Aus Elektronik, 1967, Heft 7, Dipl.-Ing. Manfred Hanemann, « Elektronische Langzeitglieder » sind elektronische Zeitkreise zur Erzielung langer Verzögerungszeiten oder Schaltzeiten bekannt. Die Zeitbestimmende Kapazität wird dabei linear aufgeladen. Zur Realisierung einer Einschaltverzögerungsschaltung ist auf Seite 208, 2.4.2., « Einschaltverzögerung », eine Schaltungsanordnung angegeben, bei der ein Transistor erst dann schaltet, wenn an der Kapazität die Zenerspannung einer Zenerdiode im Emitterkreis dieses Transistors erreicht wird. Auf Seite 209, 2.4.3., « Abschaltverzögerung », ist eine Schaltungsanordnung angegeben, bei der ein Kondensator linear über einen Transistor und einen Widerstand entladen wird. Erst nach der mittels des Kondensators, des Widerstandes und einer Diode eingestellten Verzögerungszeit, wird die eingangsseitige Potentialänderungs am Ausgang angezeigt.

Diese elektronischen Zeitkreise haben den Nachteil, daß zu Erzielung kurzer Verzögerungszeiten eine relativ aufwendige Schaltungsanordnung verwendet werden muß. Wird wie auf Seite 207 angegeben, ein monostabiles Flip-Flop als Zeitglied verwendet, so können bereits Störgrößen wie Netzschwankungen oder Störimpulse am Ausgang dieses Zeitglied auslösen. Weiterhin ist auf Seite 209 eine Diskriminatorschaltung mit einer Zenerdiode im Basiskreis eines Transistors angegeben. Nachteilig bei dieser Schaltungsanordnung ist, daß ausschließlich durch die Zenerspannung die Schwellspannung festgelegt ist und daß infolge von Exemplarschwankungen gleicher Zenerdioden unterschiedliche Schwellspannungen erzeugt werden.

Werden elektrische Geräte an Stromversorgungen angeschlossen, welche starke Spannungsschwankungen oder hohe, der Versorgungsspannung überlagerte Störspannungen aufweisen, so sind dafür Regeleinrichtungen vorgesehen. Das ist beispielsweise der Fall bei Sende- oder Empfangsgeräten von Funkfernsprechdiensten, die in Kraftfahrzeuge oder in Schiffe eingebaut werden und an eine Versorgungsgleichspannung, die Batteriespannung, angeschlossen sind.

Eine Autotelefonanlage kann ein Sprechfunkgerät, ein Bediengerät und eine Sprechstelle umfassen. Das Sprechfunkgerät besteht beispielsweise aus einem Sender, einem Empfänger und einer Selektivruf- und Wähleinrichtung (SRWE), die die Aufgabe hat, den Verbindungsauf- und Abbau zu steuern und Steuerfunktionen auszuführen, die sich aus dem Bedienungsablauf der Anlage ergeben.

Das Sprechfunkgerät kann an geeigneter Stelle des Fahrzeugs installiert (z. B. im Kofferraum) sein und wird über Kabel mit dem Bediengerät und der Sprechstelle, sowie über ein Batteriekabel an die Fahrzeugbatterie angeschlossen.

Um die Vielzahl an Steuerbefehlen, die für die Ablaufsteuerung notwendig sind, bewältigen zu können, ist beispielsweise ein Mikroprozessor vorgesehen. Seine Steuerbefehle, z. B. für die Codeumsetzung der über die Funkstrecke übertragenen codierten Ziffern, sind in Festwertspeichern sogenannte ROM's (Read Only Memory) niedergelegt, die zu verarbeitende Information, z. B. eine Rufnummer und die Kanalgruppe eines Teilnehmers, ist in einem Beliebig oft veränderbarem Schreib- oder Lesespeicher (RAM, Random Access Memory) gespeichert. Beim Ausschalten der Anlage geht der Speicherinhalt des Rufnummernspeichers in der Regel nicht verloren, da beim Abtrennen von der Fahrzeugbatterie eine in das Gerät eingebaute Batterie den Speicherinhalt festhält.

Bei Schaltvorgängen, beispielsweise beim Anlassen des Motors können Störspannungen auftreten, die der Versorgungsgleichspannung überlagert sind. Es besteht zwar die Möglichkeit, die schwankende Versorgungsgleichspannung mittels beispielsweise einer, zur Versorgungsgleichspannung parallelen Diode zu stabilisieren. Diese Maßnahme ist jedoch nur für Überspannungen wirksam. Bei Spannungseinbrüchen wie sie beispielsweise beim Anlassen und Einschalten entstehen oder beim Abschalten der Anlage auftreten können, kann der Mikroprozessor zur Ausführung unzulässiger Befehle veranlaßt werden und Speicherplätze des Schreiboder Lesespeichers beschreiben oder löschen.

Dieser Fall tritt dann auf, wenn die Betriebsspannung des Mikroprozessors aus der Versorgungsspannung abgeleitet wird und mittels Elektrolytkondensatoren spannungsstabilisiert ist, welche nach dem Abschalten der Anlage mit ihrer gespeicherten Energie den Mikroprozessor versorgen. Dadurch wird der Forderung genügt, daß für die Ablaufsteuerung mittels Mikroprozessoren, die Betriebsspannung für den Mikroprozessor länger erhalten bleibt wie die Versorgungsspannung. Ein Schutz gegen unzulässige Programmänderungen durch den Mikroprozessor ist dadurch nicht erreichbar. Für einige Einrichtungen im Gerät, z. B. Rufnummernspeicher, ist eine Umschaltung auf eine Hilfsspannungsquelle erforderlich. Dazu kann z. B. ein Schalter vorgesehen sein, der manuell betätigbar ist und mit dessen Hilfe auf die in das Gerät eingebaute Batterie umgeschaltet wird. Die Wahrscheinlichkeit, daß die Betätigung des Schalters unterbleibt, ist relativ groß. Weiterhin besteht die Forderung, daß der Schalter zeitgerecht, d. h. beim Unter- oder Überschreiten eines bestimmten Spannungswertes, bedient werden muß.

Aufgabe der Erfindungs ist es, ein elektronisches Zeitglied so anzugeben, daß bei Spannungseinbrüchen, Abschaltung oder Anschaltung der Versorgungsspannung für ein elektrisches Gerät mit Programmsteuerung, Steuerbefehle erzeugt werden, mit deren Hilfe Einrichtungen im Gerät an wenigstens eine Hilfsspannungsquelle an- oder abschaltbar sind, so daß Daten- und Programmverfälschungen verhindert werden und somit das einwandfreie Arbeiten einer speicherorientierten Einrichtung im elektrischen Gerät gewährleistet ist.

Aus der US-PS 4,096,560 ist ein elektronisches Zeitglied bekannt, welches mittels Steuersignale einen Mikroprozessor beim Anschalten der Versorgungsspannung sperrt. Dazu enthält das elektronische Zeitglied einen von einer Schwellwertschaltung gesteuerten elektronischen Schalter, der die von der Schwellwertschaltung überwachte Versorgungsspannung an eine Einschaltverzögerungs-Schaltung, welche in Form einer monostabilen Kippstufe ausgebildet ist, weiterschaltet. Wird die Versorgungsspannung angelegt, so wird der Mikroprozessor erst nach Ablauf der durch die Einschaltverzögerungs-Schaltung bestimmten Verzögerungszeit freigegeben.

Mit dem elektronischen Schalter ist weiterhin eine Auschaltverzögerungs-Schaltung verbunden. Aus der Verknüpfung der Signale am Ausgang der Einschaltverzögerungs-Schaltung und Ausschaltverzögerungs-Schaltung mit einem weiteren Hilfssignal wird ein Steuersignal für einen Speicher abgeleitet. Dieses Steuersignal steuert den Einlese- oder Auslesevorgang aus dem Speicher und ist während der Ausschalt-Verzögerungszeit wirksam. Das Steuersignal wird aus der Versorgungsspannung abgeleitet.

Weiterhin ist aus der DD-PS 142 933 ein elektronisches Zeitglied für digitale Transistorbaustufen bekannt. Im elektronischen Zeitglied ist eine Einschaltverzögerungs-Schaltung vorgesehen und aus einer Hilfsspannungsquelle wird ein Steuersignal abgeleitet, welches beim Ausschalten wirksam ist.

Beiden elektronischen Zeitgliedern ist gemeinsam, daß auch bei sehr kurzen Spannungseinbrüchen der Versorgungsspannung der Mikroprozessor bzw. die Transistorbaustufen gesperrt werden.

Diese Aufgabe wird bei einem Gegenstand nach dem Oberbegriff des Anspruchs 1 durch dessen Merkmale im kennzeichnenden Teil gelöst.

Der Erfindung liegt hierbei die Erkenntnis zu Grunde, daß durch Überwachung des momentanen Amplitudenwertes der Batteriespannung, d. h. der Versorgungsspannungsquelle, zuverlässig verhindert werden kann, daß der Mikroprozessor unzulässige Programmschritte ausführt und beispielsweise Speicherplätze beschreibt oder löscht. Dazu genügt neben einer Schwellwertschaltung und einem davon angesteuerten Schalter eine einfach gebaute Einschalt- und Ausschaltverzögerungs-Schaltung, wobei deren Signale mittels einfacher Impulsformerstufen in geeignete Steuersignale für den Mikroprozessor umgeformt werden. Die Schaltungsanordnung selbst zeichnet sich durch ihre Einfachheit und Übersichtlichkeit aus und die dafür verwendeten Komponenten sind marktgängige Bauelemente.

Weiterhin ist von Vorteil, daß durch das Steuersignal der Ausschaltverzögerungs-Schaltung der Mikroprozessor den letzten Befehl ausführen kann und die Umschaltung auf die Hilfsspannungsquelle verzögert erfolgt. Weiterhin ist von Vorteil, daß auch bei sehr kurzen Spannungseinbrüchen stets die durch die Einschaltverzögerungs-Schaltung vorgegebene Verzögerungszeit abgewartet werden muß, bevor der Mikroprozessor den ersten Befehl ausführen kann.

Weitere erfindungsgemäße Ausgestaltungen sind den Unteransprüchen entnehmbar.

Die Erfindung wird nachfolgend an Hand des in der Zeichnung dargestellten, bevorzugten Ausführungsbeispieles näher erläutert. Es zeigt :

Figur 1 ein Blockschaltbild eines elektronischen Zeitgliedes nach der Erfindung,

Figur 2 ein bevorzugtes Ausführungsbeispiel für das elektronische Zeitglied,

Figur 3 ein zum Verständnis der Funktion nützliches Impulsdiagramm beim Einschalten der Ausführungsform nach Figur 2,

Figur 4 einen Phasenplan bei Kurzausfall der Batteriespannung der Anordnung nach Figur 2,

Figur 5 ein Impulsdiagramm beim Abschalten der Anordnung nach Figur 2.

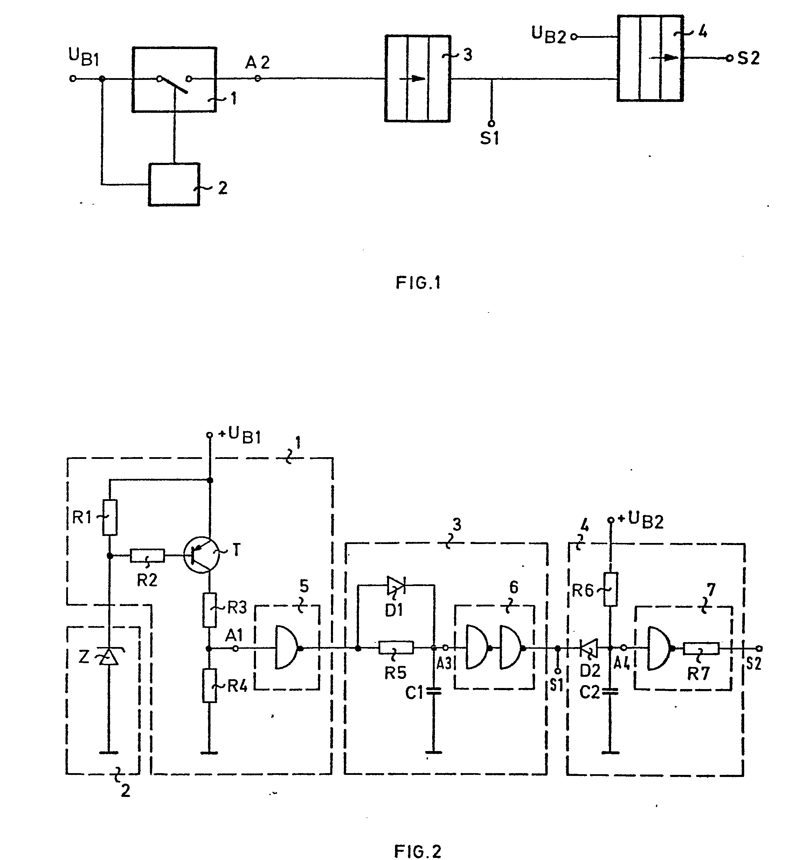

Das elektronische Zeitglied nach Figur 1 enthält eine Schwellwertschaltung 2, deren Eingang mit einem Pol einer Versorgungsspannungsquelle $U_{B1}$ verbunden ist. Mit Hilfe der Schwellwertschaltung 2 kann die Versorgungsspannungsquelle $U_{B1}$ überwacht werden. Der Ausgang der Schwellwertschaltung 2 ist mit einem Steuereingang eines elektronischen Schalters 1 verbunden. Dem elektronischen Schalter 1 wird die Versorgungsspannung $U_{B1}$ zugeführt und mittels der Schwellwertschaltung 2 an eine Einschaltverzögerungs-Schaltung 3 weitergeschaltet. Im elektronischen Schalter 1 kann eine Impulsformerstufe vorgesehen sein, mittels der die Steilheit des Ausgangssignals des elektronischen Schalters 1 verbessert und eine pegelmäßige Begrenzung des Ausgangssignals vorgenommen werden kann.

Infolge der dadurch erzielten eindeutigen Pegelvorgabe durch diese Impulsformerstufe, beziehungsweise durch die eindeutigen Schaltstellungen des elektronischen Schalters 1 wird erreicht, daß auch bei sehr kurzen Spannungseinbrüchen stets die gesamte Verzögerungszeit der Einschaltverzögerungs-Schaltung 3 durchlaufen wird. Am Ausgang der Einschaltverzögerungs-Schaltung 3 ist ein erstes Steuersignal S1 abgreifbar, welches z. B. mit einer weiteren Impulsformerstufe in ein Steuersignal mit steiler Flanke und richtiger Polarität umgeformt worden ist. Das erste Steuersignal S1 hat eine vorbereitende Wirkung für das angeschlossene elektrische Gerät und soll diesem das Unter- oder Überschreiten des Schwellwertes signalisieren. Im Bevorzugten Anwendungsfall liegt das erste Steuersignal S1 und ein zweites Steuersignal S2 solange an, bis sich für Einrichtungen im elektrischen Gerät, z. B. für den Mikroprozessor eine interne Betriebsspannung gebildet hat. Das Steuersignal S1 ist einem Eingang einer Ausschaltverzögerungs-Schaltung 4 zugeführt, an deren weiterem Eingang einer der Pole einer Hilfsspannungsquelle $U_{B2}$ anliegt. Beim Einschalten durchläuft das Steuersignal S1 ohne Verzögerung die Ausschaltverzögerungs-Schaltung 4 und steht in modifizierter Form am Ausgang der Ausschaltverzögerungs-Schaltung 4 als zweites Steuersignal S2 zur Verfügung. Beim Ausschalten oder bei Spannungseinbrüchen unter dem Schwellwert der Schwellwertschaltung 2 bewirkt die Ausschaltverzögerungs-Schaltung 4 im bevorzugten Ausführungsbeispiel, daß der Mikroprozessor den letzten Befehl ausführt und verzögert eine Umschaltung auf die Hilfsspannungsquelle $U_{B2}$ erfolgt.

Das Ausgangssignal der Ausschaltverzögerungs-Schaltung 4 kann mit Hilfe einer weiteren Impulsformerstufe in ein für Einrichtungen im elektrischen Gerät, z. B. dem Mikroprozessor geeignetes Signal richtiger Polarität umgeformt werden.

Figur 2 zeigt im Detail die Komponenten des elektronischen Zeitgliedes nach Figur 1. Die Schwelle der Schwellwertschaltung 2 wird mit Hilfe einer Zenerdiode Z erzeugt, deren Anode mit Masse verbunden ist und deren Kathode über einen Widerstand R2, mit der Basis eines Transistors T des elektronischen Schalters 1 verbunden ist. Der Emitter des Transistors T ist einerseits mit dem Pluspol der Versorgungsspannungsquelle $U_{B1}$ andererseits über einen ersten Widerstand R1 und den zweiten Widerstand R2 mit seiner Basis verbunden. Der Kollektor des Transistors T liegt über einem dritten Widerstand R3 und einem vierten Widerstand R4 an Masse. Am Verbindungspunkt des dritten und vierten Widerstandes R3, R4 ist das Eingangssignal für eine Impulsformerstufe 5 des elektronischen Schalters 1 abgreifbar, wobei als Impulsformerstufe 5 ein Inverter dient. Beim Einschalten des elektrischen Gerätes und damit beim Anschalten z. B. eines Mikroprozessors in einer Anlage des Funkfernsprechdienstes an die Versorgungsspannungsquelle $U_{B1}$, folgt die Emitterspannung des Transistors T der Basisspannung bis zum Schwellwert an der Zenerdiode Z der Schwellwertschaltung 2 vermindert um den Spannungsabfall am Widerstand R1. Der Transistor T schaltet durch und am Eingang der Impulsformerstufe 5 steht ein positives Signal, entsprechend dem Spannungsteilerverhältnis R3 zur R4, an.

Mit einem nachfolgenden RC-Glied mit R5, C1 in der Einschaltverzögerungs-Schaltung 3, ist die Verzögerungszeit entsprechend der Dimensionierung des Widerstandes R5 und des Kondensators C1 wählbar. Der Widerstand R5 ist mit einer ersten Diode D1 verbunden wobei der Anode der ersten Diode D1 das Ausgangssignal A2 der Impulsformerstufe 5 des elektronischen Schalters 1 zugeführt ist und an der Kathode der ersten Diode D1 ist ein Signal A3 der Einschaltverzögerungs-Schaltung 3 abgreifbar. Mit Hilfe der Diode D1 wird erreicht, daß das Signal A3 der Einschaltverzögerungs-Schaltung 3 verzögert ansteigt und schnell wieder abfällt. Eine nachfolgende Impulsformerstufe 6 der Einschaltverzögerungs-Schaltung 3, welche aus zwei in Serie geschalteten Invertern besteht, stellt die Polarität und Flankensteilheit des ersten Steuersignals S1 am Ausgang der Einschaltverzögerungs-Schaltung 3 sicher.

Das erste Steuersignal S1 liegt an der Kathode einer zweiten Diode D2 einer Ausschaltverzögerungs-Schaltung 4 an. Die Anode der Diode D2 ist mit einem nachfolgenden RC-Glied mit R6, C2 verbunden. Ein Anschluß des Widerstandes R6 ist mit dem Pluspol einer Hilfsspannungsquelle $U_{B2}$ verbunden und ein Anschluß des Kondensators C2 liegt an Masse. Die zweite Diode stellt sicher, daß ein Signal A4 der Ausschaltverzögerungs-Schaltung 4 rasch ansteigt und verzögert abfällt. Mit Hilfe einer am Verbindungspunkt Anode der Diode D2, Widerstand R6 und Kondensator C2 anliegenden Impulsformerstufe 7 der Ausschaltverzögerungs-Schaltung 4 wird das elektronische Zeitglied gegen den Mikroprozessor entkoppelt und das Steuersignal S2 am Ausgang der Ausschaltverzögerungs-Schaltung 4 in geeigneter Weise geformt.

Die Impulsformerstufe 7 der Ausschaltverzögerungs-Schaltung 4 besteht aus der Serienschaltung eines Inverters mit einem Widerstand R7.

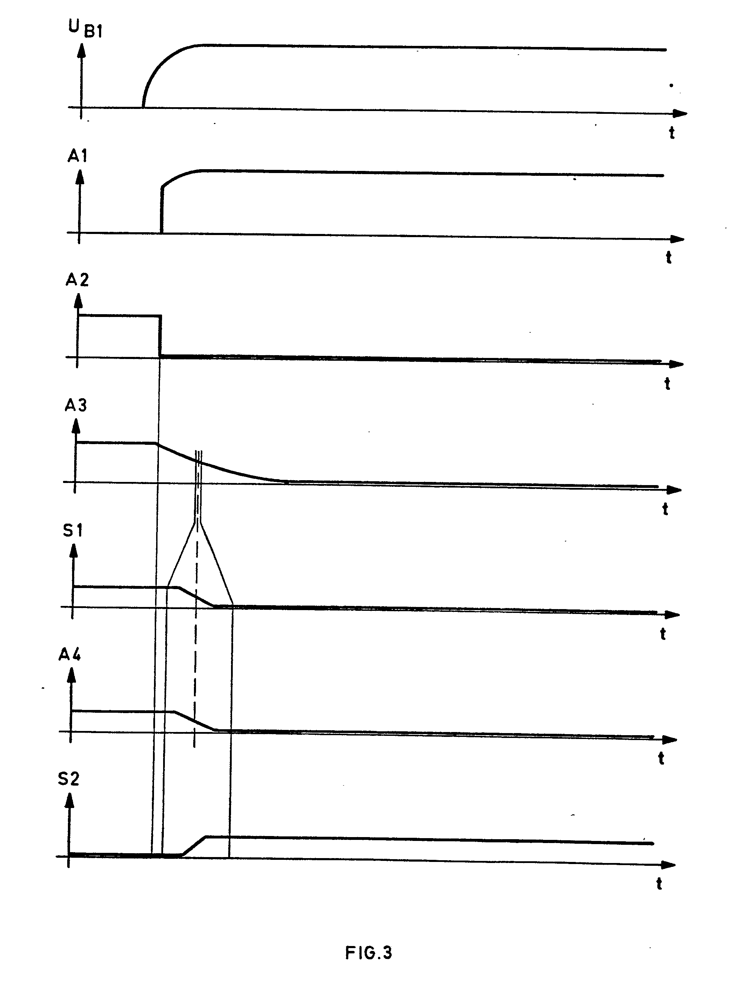

Anhand des Impulsdiagramms nach Figur 3 soll die Wirkungsweise der Komponenten des elektronischen Zeitgliedes nach Figur 2 aufgezeigt werden. Für die untereinander aufgetragenen Zeitdiagramme nach Figur 3, Figur 4 und Figur 5 ist mit $U_{B1}$ die Versorgungsspannung, mit A1 das Signal am Verbindungspunkt der Widerstände R3, R4 des elektronischen Schalters 1, mit A2 nach erfolgter Impulsformung, mit A3 das Signal am Kondensator C1 der Einschaltverzögerungs-Schaltung 3, mit S1 das erste Steuersignal, mit A4 das Signal am Kondensator C2 der Ausschaltverzögerungs-Schaltung 4 und mit S2 das zweite Steuersignal bezeichnet.

Zum Verständnis der Wirkungsweise sei vorausgesetzt, daß die Anlage ausgeschaltet, die Versorgungsspannung $U_{B1} = 0$ ist und die Hilfsspannung $U_{B2}$ einem bestimmten positiven Pegel entspricht. Der Kennzustand des ersten Steuersignals S1 ist der logische H-Pegel (Pegel der näher bei plus unendlich liegt) und der Kennzustand des zweiten Steuersignals S2 ist der logische L-Pegel (Pegel der näher bei minus unendlich liegt). Beim Einschalten der Anlage steigt die Versorgungsspannung $U_{B1}$ kontinuierlich an. Das Signal A1 des elektronischen Schalters 1 folgt ab einem bestimmten Pegel der Versorgungsspannung $U_{B1}$ nach. Mittels der Einschaltverzögerungs-Schaltung 3 behalten die Steuersignale S1 und S2 ihren Kennzustand solange bei, bis der Prozessor sich aus der Versorgungsspannung $U_{B1}$ seine interne Betriebsspannung gebildet hat.

Nach Ablauf der einstellbaren Einschaltverzögerungszeit findet ein Kennzustandswechsel der beiden Steuersignale S1 und S2 statt und der Mikroprozessor nimmt seinen normalen Programmablauf auf. Der Kennzustandswechsel der Steuersignale S1 und S2 ist in Figur 3 durch die Zeitdehnung deutlich herausgestellt.

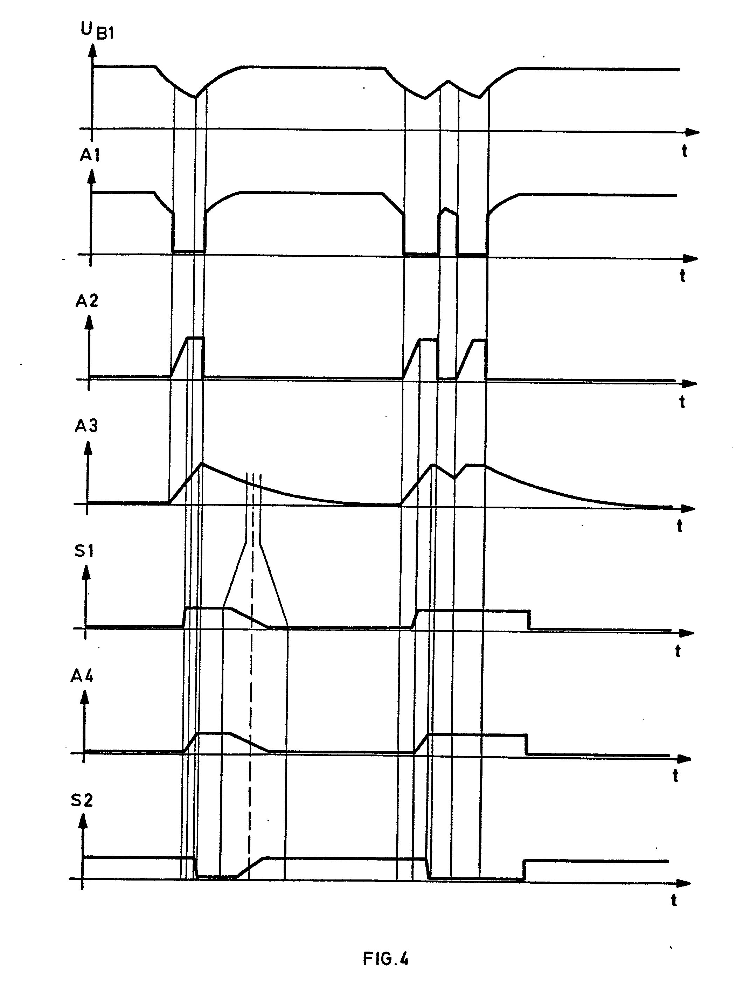

Im Phasenplan nach Figur 4 sind die Ausgangssignale der einzelnen Komponenten des elektronischen Zeitgliedes, bei kurzem Ausfall oder Absinken der Versorgungsspannung $U_{B1}$ unter den Schwellwert dargestellt. Beim Absinken unter eine bestimmte Schaltschwelle ändert sich der Kennzustand des ersten Steuersignals S1 sofort, während ein Kennzustandswechsel des Steuersignals S2, entsprechend der eingestellten Verzögerungszeit der Ausschaltverzögerungs-Schaltung 4, verzögert stattfindet. Diese Einstellung kann beispielsweise durch die Wahl der Werte für den Widerstand R6 und den Kondensator C2 oder durch Verwendung eines Potentiometers für den Widerstand R6 durchgeführt werden. Bei Spannungswiederkehr über einen durch die Schwellwertschaltung 2 überwachten Pegel der Versorgungsspannung $U_{B1}$ ist die Einschaltzögerungs-Schaltung 3 wirksam und der Verlauf der Signale entspricht denen nach Figur 3.

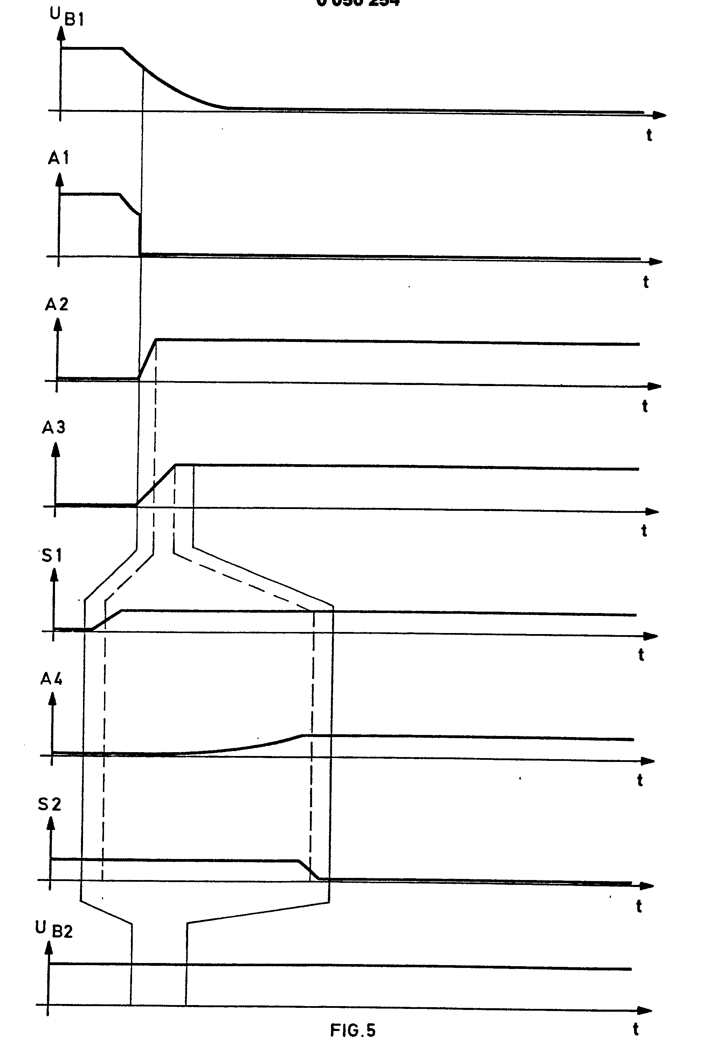

Im Phasenplan nach Figur 5 ist der Verlauf der Signale beim Abschalten der Anlage dargestellt. Sinkt die Versorgungsspannung $U_{B1}$ unter einen bestimmten Pegel ab, so ändert das Steuersignal S1 sofort seinen Kennzustand. Die in Figur 5, in Zeitdehnungsmaßstab dargestellte Flanke des ersten Steuersignals S1, ergibt sich aus der Entladung des Kondensators C1 über die erste Diode D1.

Der Kondensator C2 wird über den Widerstand R6 aufgeladen, wobei die Kondensatorspannung den in der Figur 5 dargestellten Verlauf einer e-Funktion hat. Durch die Ausschaltverzögerungs-Schaltung 4, d. h. verzögerter Kennzustandswechsel des Steuerbefehls S2 kann der Mikroprozessor seinen letzten Befehl ausführen. Die Steuersignale S1 und S2 werden nach dem Abschalten der Versorgungsspannung $U_{B1}$ durch die Hilfsspannungsquelle $U_{B2}$ aufrechterhalten, so daß auch bei Wiederkehr der Versorgungsspannung $U_{B1}$ Steuersignale mit eindeutiger Polarität zur Verfügung stehen und der Mikroprozessor sich in einem eindeutigen Funktionszustand befindet.

Das elektronische Zeitglied ist zwischen der Stromversorgungseinrichtung des elektrischen Gerätes und wenigstens einer Einrichtung im Gerät angeordnet. Neben dem bevorzugten Anwendungsfall für eine Anlage des Funkfernsprechdienstes sind weitere Anwendungsfälle, z. B. in programmgesteuerten Rundfunk- oder Casettengeräten oder Werkbänken möglich. Allen Anwendungsfällen ist gemeinsam, daß eine Programmsteuerung auf speicherorientierte Einrichtungen einwirkt, daß die Programmsteuerung bei Spannungsveränderung der Versorgungsspannung unter oder über eine bestimmte Schwelle keine unzulässigen Steuerbefehle erzeugen soll und daß ab einer bestimmten Schwelle, für wenigstens eine speicherorientierte Einrichtung, eine Umschaltung zwischen der Versorgungsspannungsquelle und wenigstens einer Hilfsspannungsquelle erfolgt.

**Ansprüche**

1. Elektronisches Zeitglied zur Erzeugung von Steuersignalen für ein elektrisches Gerät, welches eine Stromversorgungseinrichtung und davon gespeiste Einrichtung enthält, die beim Anschalten, Abschalten oder bei Spannungseinbrüchen der Versorgungsspannung mittels dieser Steuersignale an wenigstens eine Hilfsspannungsquelle an- oder davon abschaltbar sind, welches einen von einer Schwellwertschaltung (2) gesteuerten elektronischen Schalter (1) enthält, der die von der Schwellwertschaltung (2) überwachte Versorgungsspannung an eine Einschaltverzögerungsschaltung (3) weiterschaltet, an deren Ausgang ein erstes Steuersignal (S1) abgreifbar ist, dadurch gekennzeichnet, daß das erste Steuersignal (S1) einer Ausschaltverzögerungs-Schaltung (4) zugeführt ist, daß ein weiterer Eingang der Ausschaltverzögerungs-Schaltung (4) mit wenigstens einer Hilfsspannungsquelle ($U_{B2}$) verbunden ist und daß beim Anschalten oder Abschalten oder bei Spannungseinbrüchen der Versorgungsspannung ($U_{B1}$), wenigstens eine der Einrichtungen mittels wenigstens einem zweiten Steuersignal (S2) am Ausgang der Ausschaltverzögerungs-Schaltung (4) mit wenigstens einer Hilfsspannungsquelle ($U_{B2}$) verbindbar ist.

2. Elektronisches Zeitglied nach Anspruch 1, dadurch gekennzeichnet, daß als Schwellwertschaltung (2) eine Zenerdiode (Z) dient.

3. Elektronisches Zeitglied nach Anspruch 1 oder 2, dadurch gekennzeichnet, daß der elektronische Schalter (1) einen Transistor (T), einen ersten und einen zweiten Widerstand (R1, R2), einen Spannungsteiler (R3, R4) und eine Impulsformerstufe (5) enthält, daß der Emitter des Transistors (T) einerseits mit dem Pluspol der Versorgungsspannungsquelle ($U_{B1}$), andererseits über den ersten Widerstand (R1) und den zweiten Widerstand (R2) mit seiner Basis verbunden ist, daß am Verbindungspunkt des ersten und zweiten Widerstandes (R1, R2) die Kathode der Zenerdiode (Z) anliegt und daß der Kollektor des Transistors (T) über den Spannungsteiler (R3, R4) an Masse liegt, wobei am Verbindungspunkt der Widerstände (R3, R4) des Spannungsteilers das Eingangssignal für die Impulsformerstufe (5) des elektronischen Schalters (1) abgreifbar ist.

4. Elektronisches Zeitglied nach Anspruch 1 oder 3, dadurch gekennzeichnet, daß als Impulsformerstufe (5) des elektronischen Schalters (1) ein Inverter dient.

5. Elektronisches Zeitglied nach Anspruch 1, dadurch gekennzeichnet, daß die Einschaltverzögerungs-Schaltung (3) in bekannter Weise als RC-Glied (R5, C1) ausgebildet ist, daß parallel zum Widerstand (R5) eine erste Diode (D1) angeordnet ist, wobei der Anode der ersten Diode (D1) das Ausgangssignal der Impulsformerstufe (5) des elektronischen Schalters (1) zugeführt ist und daß an der Kathode der ersten Diode (D1) das Eingangssignal für eine Impulsformerstufe (6) der Einschaltverzögerungs-Schaltung (3) anliegt.

6. Elektronisches Zeitglied nach Anspruch 1 oder 5, dadurch gekennzeichnet, daß als Impulsformerstufe (6) der Einschaltverzögerungs-Schaltung (3) zwei in Serie geschaltete Inverter dienen.

7. Elektronisches Zeitglied nach Anspruch 1, dadurch gekennzeichnet, daß die Ausschaltverzögerungs-Schaltung (4) aus der Serienschaltung einer zweiten Diode (D2) mit einem RC-Glied (R6, C2) besteht, daß ein Anschluß des Widerstandes (R6) mit dem Pluspol der Hilfsspannungsquelle (U$_{B2}$) und der andere Anschluß mit der Anode der zweiten Diode (D2), sowie mit einem Anschluß des Kondensators (C6), dessen weiterer Anschluß an Masse liegt, verbunden ist und das an der Anode der zweiten Diode (D2) das Eingangssignal für eine Impulsformerstufe (7) der Ausschaltverzögerungs-Schaltung (4) anliegt.

8. Elektronisches Zeitglied nach Anspruch 1 oder 7, dadurch gekennzeichnet, daß die Impulsformerstufe (7) der Ausschaltverzögerungs-Schaltung (4) aus der Serienschaltung eines Inverters mit einem Widerstand (R7) besteht.

## Claims

1. An electronic timer for producing control signals for an electric apparatus, comprising a power supply arrangement and a device supplied thereby, which on switch-on, switch-off or in the event of voltage drops of the supply voltage is connectable to or disconnectable from at least one auxiliary voltage source by means of these control signals, also comprising an electronic switch (1) which conveyes the supply voltage which is supervised by a threshold value circuit (2) and is controlled by this threshold value circuit (2) to a turn-on delay circuit (3) from whose output a first control signal (S1) can be taken, characterized in that the first control signal (S1) is applied to a turn-off delay circuit (4), that a further input of the turn-off delay circuit (4) is connected to at least one auxiliary voltage source (U$_{B2}$) and that on switch-on, switch-off or in the event of voltage drops of the supply-voltage (U$_{B1}$) at least one of the devices is connectable to at least one auxiliary voltage circuit (U$_{B2}$) by means of at least a second control signal (S2) at the output of the turn-off delay circuit (4).

2. An electronic timer as claimed in claim 1, characterized in that a zener diode (Z) is used as the threshold value circuit (2).

3. An electronic timer as claimed in claim 1 or 2, characterized in that the electronic switch (1) comprises a transistor (T), first and second resistors (R1, R2), a voltage divider (R3, R4) and a pulse-shaper stage (5), that the emitter of the transistor (T) is connected to the positive pole of the supply-voltage source (U$_{B1}$) and also to its base via the first resistor (R1) and the second resistor (R2), that the cathode of the zener diode (Z) is connected to the junction between the first and second transistors (R1, R2) and that the collector of the transistor (T) is connected to ground via the voltage divider (R3, R4), the input signal for the pulse-shaper stage (5) of the electronic switch (1) being available at the junction between the resistors (R3, R4) of the voltage divider.

4. An electronic timer as claimed in claim 1 or 3, characterized in that an inverter is used as the pulse-shaper stage (5) of the electronic switch (1).

5. An electronic timer as claimed in claim 1, characterized in that the turn-on delay circuit (3) is formed in known manner as an RC-network (R5, C1), that a first diode (D1) is arranged in parallel with the resistor (R5), the output signal of the pulse-shaper stage (5) of the electronic switch (1) being applied to the anode of the first diode (D1) and that the input signal for a pulse-shaper stage (6) of the turn-on delay circuit (3) is connected to the cathode of the first diode (D1).

6. An electronic timer as claimed in claim 1 or 5, characterized in that two series-arranged inverters are used as the pulse-shaper stage (6) of the turn-on delay circuit (3).

7. An electronic timer as claimed in claim 1, characterized in that the turn-off delay circuit (4) is constituted by the series arrangement of a second diode (D2) and a RC-network (R6, C2), that a terminal of the resistor (R6) is connected to the positive pole of the auxiliary voltage source (U$_{B2}$) and the other terminal to the anode of the second diode (D2), and also to a terminal of the capacitor (C6) whose further terminal is connected to ground, and that the input signal for a pulse-shaper stage (7) of the turn-off delay circuit (4) is connected to the anode of the second diode (D2).

8. An electronic timer as claimed in claim 1 or 7, characterized in that the pulse-shaper stage (7) of the turn-off delay circuit (4) is constituted by the series arrangement of an inverter and a resistor (R7).

## Revendications

1. Elément électronique temporisé destiné à produire des signaux de commande pour un appareil électrique, qui comprend un dispositif d'alimentation de courant et un dispositif alimenté par ce dispositif d'alimentation qui, dans le cas de l'enclenchement, du déclenchement ou de l'interruption de la tension d'alimentation, peuvent être connectés au moyen de ces signaux de commande à au moins une source de tension auxiliaire ou être déconnectés de celle-ci, qui comprend un interrupteur électronique (1) commandé par un circuit à seuil (2), qui renvoie la tension d'alimentation surveillée par le circuit à seuil (2) à un circuit de temporisation à l'enclenchement à la sortie duquel un premier signal de commande (S1) peut être obtenu, caractérisé en ce que le premier signal de commande (S1) est amené à un circuit de temporisation au déclenchement (4), une autre entrée du circuit de temporisation au déclenchement (4) est connectée à au moins une source de tension auxiliaire ($U_{B2}$) et, dans le cas de l'enclenchement, du déclenchement ou de l'interruption de la tension d'alimentation ($U_{B1}$), au moins un des dispositifs peut être connecté au moyen d'au moins un deuxième signal de commande (S2) présent à la sortie du circuit de temporisation au déclenchement (4) à au moins une source de tension auxiliaire ($U_{B2}$).

2. Elément électronique temporisé suivant la revendication 1, caractérisé en ce qu'une diode Zener (Z) sert de circuit à seuil (2).

3. Elément électronique temporisé suivant la revendication 1 ou 2, caractérisé en ce que l'interrupteur électronique (1) comprend un transistor (T), une première et une deuxième résistances (R1, R2), un diviseur de tension (R3, R4) et un étage conformateur d'impulsions (5), l'émetteur du transistor (T) est connecté d'une part au pôle plus de la source de tension d'alimentation ($U_{B1}$) et, d'autre part, à sa base par l'intermédiaire de la première résistance (R1) et de la deuxième résistance (R2), au point de jonction de la première et de la deuxième résistances (R1, R2) est connectée la cathode de la diode Zener (Z) et le collecteur du transistor (T) est mis à la masse par l'intermédiaire du diviseur de tension (R3, R4), le signal d'entrée pour l'étage conformateur d'impulsions (5) de l'interrupteur électronique (1) pouvant être obtenu au point de jonction des résistances (R3, R4) du diviseur de tension.

4. Elément électronique temporisé suivant la revendication 1 ou 3, caractérisé en ce qu'un inverseur sert d'étage conformateur d'impulsions (5) de l'interrupteur électronique (1).

5. Elément électronique temporisé suivant la revendication 1, caractérisé en ce que le circuit de temporisation à l'enclenchement (3) a, d'une manière connue, la forme d'un élément RC (R5, C1), parallèlement à la résistance (R5) est prévue une première diode (D1), l'anode de cette première diode (D1) recevant le signal de sortie de l'étage conformateur d'impulsions (5) de l'interrupteur électronique (1) et à la cathode de la première diode (D1) est appliqué le signal d'entrée pour un étage conformateur d'impulsions (6) du circuit de temporisation à l'enclenchement (3).

6. Elément électronique temporisé suivant la revendication 1 ou 5, caractérisé en ce que deux inverseurs connectés en série servent d'étage conformateur d'impulsions (6) du circuit de temporisation à l'enclenchement (3).

7. Elément électronique temporisé suivant la revendication 1, caractérisé en ce que le circuit de temporisation au déclenchement (4) est formé du montage en série d'une deuxième diode (D2) avec un élément RC (R6, C2), une connexion de la résistance (R6) est connectée au pôle plus de la source de tension auxiliaire ($U_{B2}$) et l'autre connexion est connectée à l'anode de la deuxième diode (D2), ainsi qu'à une connexion du condensateur (C2) dont l'autre connexion est mise à la masse, et à l'anode de la deuxième diode (D2) est présent le signal d'entrée pour un étage conformateur d'impulsions (7) du circuit de temporisation au déclenchement (4).

8. Elément électronique temporisé suivant la revendication 1 ou 7, caractérisé en ce que l'étage conformateur d'impulsions (7) du circuit de temporisation au déclenchement (4) est formé du montage en série d'un inverseur et d'une résistance (R7).

FIG.1

FIG.2

FIG.3

FIG.4

FIG.5